# FASCICULE DE BREVET EUROPEEN

(11) **EP 3 384 531 B1**
(45) Date de publication et mention de la délivrance du brevet: **25.03.2020**
(21) Numéro de dépôt: 16819145.0
(22) Date de dépôt: 01.12.2016
(51) Int. Cl.: H01L 27/15, H01L 33/38

(54) **DISPOSITIF OPTOELECTRONIQUE COMPRENANT UN COMPOSANT ELECTROLUMINESCENT ET UN TRANSISTOR**
OPTOELEKTRONISCHE VORRICHTUNG MIT EINEM LICHTEMITTIERENDEN BAUELEMENT UND EINEM TRANSISTOR
OPTOELECTRONIC DEVICE COMPRISING A LIGHT-EMITTING COMPONENT AND A TRANSISTOR

(30) Priorité: 03.12.2015 FR 1561797
(43) Date de publication de la demande: 10.10.2018
(73) Titulaire: Commissariat à l'Energie Atomique et aux Energies Alternatives, 75015 Paris (FR)
(72) Inventeur: ROBIN, Ivan-Christophe, 38000 Grenoble (FR); BONO, Hubert, 38000 Grenoble (FR); BOUCHET, Thierry, 38700 Corenc (FR); CHARLES, Matthew, 38000 Grenoble (FR); ESCOFFIER, René, 38500 La Buisse (FR); MORVAN, Erwan, 38160 Montagne (FR)
(74) Mandataire: Cabinet Beaumont
(86) Numéro de dépôt international: PCT/FR2016/053173
(87) Numéro de publication internationale: WO 2017/093678

(56) Documents cités:
- US-A- 5 021 361
- YA-JU LEE ET AL.: "Monolithic integration of GaN-based light-emitting diodes and metal-oxide-semiconductor field-effect transistors", OPTICS EXPRESS, vol. 22, no. s6, 1 octobre 2014 (2014-10-01), pages A1589-A1595, XP002762880, DOI: 10.1364/OE.22.0A1589
- LI Z ET AL: "Monolithic integration of light-emitting diodes and power metal-oxide-semiconductor channel high-electron-mobility transistors for light-emitting power integrated circuits in GaN on sapphire substrate", APPLIED PHYSICS LETTERS, A I P PUBLISHING LLC, US, vol. 102, no. 19, 13 mai 2013 (2013-05-13) , pages 192107-192107, XP012172958, ISSN: 0003-6951, DOI: 10.1063/1.4807125 [extrait le 2013-05-16]
- LIU CHAO ET AL: "Metal-interconnection-free integration of InGaN/GaN light emitting diodes with AlGaN/GaN high electron mobility transistors", APPLIED PHYSICS LETTERS, A I P PUBLISHING LLC, US, vol. 106, no. 18, 4 mai 2015 (2015-05-04), XP012197343, ISSN: 0003-6951, DOI: 10.1063/1.4921049 [extrait le 1901-01-01]

## Description

La présente demande de brevet revendique la priorité de la demande de brevet français FR15/61797.

### Domaine

La présente demande concerne un dispositif opto-électronique comprenant un composant électroluminescent et un transistor de commande du composant électroluminescent.

### Exposé de l'art antérieur

Il est connu de commander un composant électroluminescent, notamment une diode électroluminescente, par un transistor, notamment un transistor à effet de champ à grille métal-oxyde, également appelé transistor MOS, par exemple dans le cas où le composant électroluminescent est alimenté par une tension alternative.

Il peut être souhaitable que le composant électro-luminescent et le transistor MOS soient réalisés de façon intégrée, notamment lorsque le transistor MOS doit être un transistor rapide, c'est-à-dire pouvant commuter à une fréquence comprise entre 300 kHz et 1 MHz.

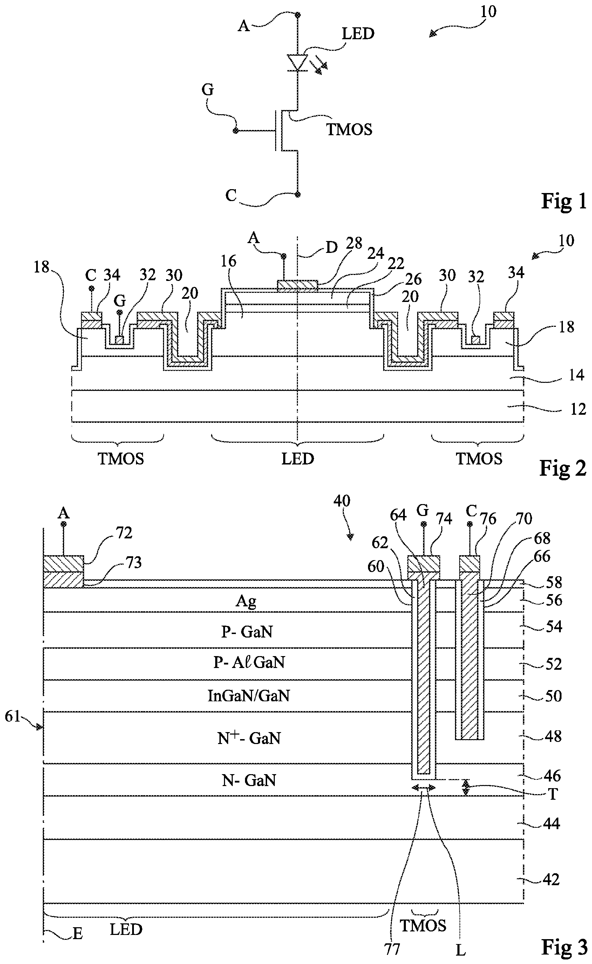

La figure 1 représente un schéma électrique d'un dispositif optoélectronique 10 comprenant une diode électroluminescente LED montée en série avec un transistor TMOS à effet de champ à grille métal-oxyde, par exemple à canal N. L'anode de la diode électroluminescente LED est reliée à un noeud A. La cathode de la diode électroluminescente LED est reliée au drain du transistor TMOS. La source du transistor TMOS est reliée à un noeud C. La grille du transistor TMOS est reliée à un noeud G.

La figure 2 est une reproduction de la figure 1 de la publication intitulée "Monolithic integration of GaN-based light-emitting diodes and metal-oxide-semiconductor field-effect transistors" de Lee et al (Optics Express, Vol. 22, Issue S6, pp. A1589-A1595, 2014) et est une vue en coupe d'un exemple de réalisation du dispositif optoélectronique 10 dans lequel la diode électroluminescente LED et le transistor MOS sont formés de façon intégrée.

Plus précisément, le dispositif optoélectronique 10, représenté en figure 2, a sensiblement une structure à symétrie de révolution autour d'un axe D et comprend, du bas vers le haut :
un substrat 12 isolant en saphir ;
une couche 14 de GaN non intentionnellement dopée ;
une portion centrale cylindrique 16 de GaN dopée de type N ;
une portion annulaire 18 de GaN dopée de type N, séparée de la portion centrale 16 par un évidement 20 annulaire ;
sur la portion centrale 16, une couche active 22 comprenant des puits quantiques multiples ;
sur la couche active 22, une couche 24 de GaN dopée de type P ;
une couche isolante 26 recouvrant l'ensemble de la structure ;
un plot conducteur 28, formé d'un empilement de plusieurs couches, au contact de la couche 24 de GaN dopée de type P au travers de la couche isolante 26 et destiné à être relié au noeud A ;
une piste de connexion 30 annulaire, formée d'un empilement de plusieurs couches, s'étendant sur la couche isolante 26 et dont le bord externe est au contact de la portion annulaire 18 de GaN au travers de la couche isolante 26 et dont le bord interne est au contact de la portion centrale 16 au travers de la couche isolante 26, la piste de connexion 30 pouvant être reliée à un plot conducteur, non représenté, permettant l'application d'une tension externe ;
un plot conducteur annulaire 32 s'étendant sur la couche isolante 26 et formant la grille du transistor TMOS, le plot 32 étant destiné à être relié au noeud G ; et
un plot conducteur 34 annulaire, formé d'un empilement de plusieurs couches, au contact de la portion annulaire 18 de GaN au travers de la couche isolante 26 et destiné à être relié au noeud C.

Bien que le dispositif optoélectronique représenté en figure 2 fonctionne correctement, il présente plusieurs inconvénients. Un inconvénient est qu'il peut être difficile de réaliser un dispositif optoélectronique 10 qui soit compact en raison de la présence de l'évidement 20. Un autre inconvénient est que la surface supérieure du dispositif optoélectronique 10, sur laquelle sont formés les plots 28, 32 et 34, est irrégulière. Ceci peut rendre difficile la fixation du dispositif optoélectronique à un autre circuit électronique du côté de la face supérieure.

De plus, la portion centrale cylindrique 16 et la portion annulaire 18 sont formées par la gravure de l'évidemment 20 dans la couche semiconductrice GaN dopée de type N. La concentration de dopants de cette couche est généralement élevée pour obtenir un bon fonctionnement de la diode électroluminescente. La concentration de dopants au niveau du canal du transistor TMOS est donc également élevée, ce qui impose une faible épaisseur de la portion annulaire 18 au niveau du canal du transistor TMOS. Un inconvénient est que la formation d'un canal fin peut être difficile avec les procédés de gravure mis en oeuvre pour la formation de la portion annulaire 18 de GaN dans la mesure où l'arrêt de la gravure doit être réalisé dans la couche de GaN dopée de type N. En effet, il ne peut pas être prévu de couche d'arrêt de gravure qui perturberait le fonctionnement de la diode électroluminescente.

Le document US 5 021 361 A divulgue un dispositif optoélectronique intégrant une LED et un transistor à effet de champ.

### Résumé

Ainsi, un objet d'un mode de réalisation est de pallier au moins en partie les inconvénients des dispositifs optoélectroniques décrits précédemment et de leurs procédés de fabrication.

Un autre objet d'un mode de réalisation est que la compacité du dispositif optoélectronique est augmentée.

Un autre objet d'un mode de réalisation est que la surface supérieure du dispositif optoélectronique est sensiblement plane.

Un autre objet d'un mode de réalisation est que le procédé de fabrication du dispositif optoélectronique est simple.

Ainsi, un mode de réalisation prévoit un dispositif optoélectronique comprenant un composant électroluminescent et un transistor à effet de champ, le dispositif optoélectronique comprenant :
une première couche semiconductrice d'un composé III-V ou II-VI dopée d'un premier type de conductivité ;
une couche active du composant électroluminescent ;
une deuxième couche semiconductrice du composé III-V ou II-VI dopée d'un deuxième type de conductivité opposé au premier type, la couche active étant prise en sandwich entre les première et deuxième couches semiconductrices,
dans lequel le canal du transistor à effet de champ est situé dans la première couche semiconductrice, la première couche semiconductrice étant ininterrompue entre le transistor à effet de champ et le composant électroluminescent.

Le dispositif optoélectronique comprend une première tranchée traversant successivement au moins la deuxième couche semiconductrice, la couche active et seulement une partie de la première couche semiconductrice, et contenant un premier coeur conducteur électriquement et une première couche isolante électriquement recouvrant les parois de la première tranchée au moins entre le premier coeur conducteur électriquement et la deuxième couche semiconductrice et entre le premier coeur conducteur électriquement et la couche active.

Selon un mode de réalisation, la première couche isolante électriquement recouvre les parois de la première tranchée entre le premier coeur conducteur électriquement et la première couche semiconductrice.

Selon un mode de réalisation, le premier coeur conducteur électriquement est en contact avec la première couche semiconductrice.

Selon un mode de réalisation, le travail de sortie du matériau composant le premier coeur conducteur électriquement est supérieur à 4 eV.

Selon un mode de réalisation, le dispositif optoélectronique comprend, en outre, une troisième couche semiconductrice du composé III-V ou II-VI dopée du premier type de conductivité ayant une concentration de dopants supérieure à la concentration de dopants de la première couche semiconductrice, au contact de la première couche semiconductrice et interposée entre la première couche semiconductrice et la couche active.

Selon un mode de réalisation, le dispositif optoélectronique comprend une deuxième tranchée traversant successivement au moins la deuxième couche semiconductrice, la couche active et la totalité ou une partie de la troisième couche semiconductrice, et contenant un deuxième coeur conducteur électriquement en contact avec la troisième couche semiconductrice et contenant une deuxième couche isolante électriquement recouvrant les parois de la deuxième tranchée au moins entre le deuxième coeur conducteur électriquement et la deuxième couche semiconductrice et entre le deuxième coeur conducteur électriquement et la couche active.

Selon un mode de réalisation, le dispositif optoélectronique comprend un premier plot conducteur électriquement en contact avec le premier coeur conducteur électriquement et un deuxième plot conducteur électriquement en contact avec le deuxième coeur conducteur électriquement, les premier et deuxième plots reposant sur une surface plane.

Selon un mode de réalisation, la couche active est la couche d'où est émise la majorité du rayonnement électromagnétique fourni par le dispositif optoélectronique.

Selon un mode de réalisation, la couche active comprend un puits quantique unique ou des puits quantiques multiples.

Selon un mode de réalisation, la concentration de dopants de la première couche semiconductrice est comprise entre 10¹⁵ atomes/cm³ et 10¹⁸ atomes/cm³, de préférence entre 5.10¹⁶ atomes/cm³ et 5.10¹⁷ atomes/cm³.

Selon un mode de réalisation, l'épaisseur de la deuxième couche semiconductrice en vis-à-vis de la première tranchée est comprise entre 50 nm et 150 nm lorsque la concentration de dopants de la deuxième couche semiconductrice est supérieure à 10¹⁷ atomes/cm³.

Selon un mode de réalisation, l'épaisseur du premier coeur conducteur électriquement est comprise entre 10 fois et 50 fois l'épaisseur de la première couche semiconductrice en vis-à-vis de la première tranchée.

Un autre mode de réalisation prévoit un procédé de fabrication d'un dispositif optoélectronique comprenant un composant électroluminescent et un transistor à effet de champ, le procédé comprenant les étapes successives suivantes :
former une première couche semiconductrice d'un composé III-V ou II-VI dopée d'un premier type de conductivité ;
former une couche active du composant électroluminescent ;
former une deuxième couche semiconductrice du composé III-V ou II-VI dopée d'un deuxième type de conductivité opposé au premier type, la couche active étant prise en sandwich entre les première et deuxième couches semiconductrices ; et
former le canal du transistor à effet de champ dans la première couche semiconductrice, la première couche semiconductrice étant ininterrompue entre le transistor à effet de champ et le composant électroluminescent.

Le procédé comprend, en outre, les étapes suivantes :
former une première tranchée traversant successivement au moins la deuxième couche semiconductrice, la couche active et seulement une partie de la première couche semiconductrice ; et
former, dans la première tranchée, un premier coeur conducteur électriquement et une première couche isolante électriquement recouvrant les parois de la première tranchée au moins entre le premier coeur conducteur électriquement et la deuxième couche semiconductrice et entre le premier coeur conducteur électriquement et la couche active.

Selon un mode de réalisation, le procédé comprend, en outre, l'étape de formation d'une troisième couche semiconductrice du composé III-V ou II-VI dopée du premier type de conductivité ayant une concentration de dopants supérieure à la concentration de dopants de la première couche semiconductrice, au contact de la première couche semiconductrice et interposée entre la première couche semiconductrice et la couche active.

Selon un mode de réalisation, le procédé comprend, en outre, les étapes suivantes :
former une deuxième tranchée traversant successivement au moins la deuxième couche semiconductrice, la couche active et seulement une partie de la troisième couche semiconductrice ; et
former, dans la deuxième tranchée, un deuxième coeur conducteur électriquement en contact avec la troisième couche semiconductrice et une deuxième couche isolante électriquement recouvrant les parois de la deuxième tranchée au moins entre le deuxième coeur conducteur électriquement et la deuxième couche semiconductrice et entre le deuxième coeur conducteur électriquement et la couche active.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1, décrite précédemment, représente un schéma électrique équivalent d'un dispositif optoélectronique comprenant une diode électroluminescente et un transistor MOS ;
la figure 2, décrite précédemment, est une vue en coupe d'un exemple de réalisation intégrée du dispositif optoélectronique représenté en figure 1 ;
les figures 3 et 4 sont respectivement une vue en coupe et une vue de dessus, partielles et schématiques, d'un mode de réalisation intégrée du dispositif optoélectronique représenté en figure 1 ;
la figure 5 est une vue en coupe, partielle et schématique, d'un système optoélectronique comprenant le dispositif optoélectronique représenté en figure 3 ;
les figures 6 à 9 représentent des courbes d'évolution du courant traversant la diode électroluminescente du dispositif optoélectronique représenté en figure 3 en fonction de la tension entre les noeuds A et C du dispositif optoélectronique pour différentes tensions appliquées à la grille du transistor MOS du dispositif optoélectronique ; et
les figures 10A à 10F sont des vues en coupe, partielles et schématiques, des structures obtenues à des étapes successives d'un mode de réalisation d'un procédé de fabrication du dispositif optoélectronique représenté en figure 3.

### Description détaillée

Par souci de clarté, de mêmes éléments ont été désignés par de mêmes références aux différentes figures et, de plus, comme cela est habituel dans la représentation des circuits électroniques, les diverses figures ne sont pas tracées à l'échelle. En outre, seuls les éléments utiles à la compréhension de la présente description ont été représentés et sont décrits. En particulier, les moyens d'alimentation des dispositifs optoélectroniques décrits ci-après sont à la portée de l'homme de l'art et ne sont pas décrits. Sauf précision contraire, les expressions "approximativement", "sensiblement", et "de l'ordre de" signifient à 10 % près, de préférence à 5 % près.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence à l'orientation des figures ou à un dispositif optoélectronique dans une position normale d'utilisation.

La présente demande concerne un dispositif optoélectronique comprenant un composant électroluminescent, par exemple une diode électroluminescente, comprenant une couche active prise en sandwich entre une première couche semiconductrice et une deuxième couche semiconductrice. Les première et deuxième couches semiconductrices sont, au moins en partie, formées à partir d'au moins un matériau semiconducteur choisi parmi le groupe comprenant les composés III-V et les composés II-VI.

Le matériau semiconducteur peut comprendre majoritairement un composé III-V, par exemple un composé III-N. Des exemples d'éléments du groupe III comprennent le gallium (Ga), l'indium (In) ou l'aluminium (Al). Des exemples d'éléments du groupe V comprennent l'azote, le phosphore ou l'arsenic. Des exemples de composés III-V sont GaN, AlN, InN, InGaN, AlGaN, AlInGaN, AlₓGa_{y}In_{(1-x-y}), AsₐP₍₁₋ₐ₎ ou InP. De façon générale, les éléments dans le composé III-V peuvent être combinés avec différentes fractions molaires.

Le matériau semiconducteur peut comprendre majoritairement un composé II-VI. Des exemples d'éléments du groupe II comprennent des éléments du groupe IIA, notamment le béryllium (Be) et le magnésium (Mg) et des éléments du groupe IIB, notamment le zinc (Zn), le cadmium (Cd) et le mercure (Hg). Des exemples d'éléments du groupe VI comprennent des éléments du groupe VIA, notamment l'oxygène (O), le soufre (S), le sélénium (Se) et le tellure (Te). Des exemples de composés II-VI sont ZnO, ZnMgO, CdZnO, CdZnMgO, CdHgTe, CdTe, HgTe, ZnSe ou ZnS. De façon générale, les éléments dans le composé II-VI peuvent être combinés avec différentes fractions molaires.

Le matériau semiconducteur peut comprendre un dopant. A titre d'exemple, pour des composés III-V, le dopant peut être choisi parmi le groupe comprenant un dopant de type P du groupe II, par exemple, du magnésium (Mg), du zinc (Zn), du cadmium (Cd) ou du mercure (Hg), un dopant du type P du groupe IV, par exemple du carbone (C) ou un dopant de type N du groupe IV, par exemple du silicium (Si), du germanium (Ge), de l'étain (Sn), ou du groupe VI comme du sélénium (Se), du souffre (S), ou du terbium (Tb). De préférence, pour le GaN, le dopant de type P est le magnésium et le dopant de type N est le silicium.

La couche active est la couche depuis laquelle est émise la majorité du rayonnement fourni par le dispositif optoélectronique. La couche active peut comporter des moyens de confinement. A titre d'exemple, la couche peut comprendre un puits quantique unique. Elle comprend alors un matériau semiconducteur différent du matériau semiconducteur formant la première couche semiconductrice et la deuxième couche semiconductrice et ayant une bande interdite inférieure à celle du matériau formant la première couche semiconductrice et la deuxième couche semiconductrice. A titre d'exemple, lorsque les couches semiconductrices sont majoritairement en un composé III-V, la couche active peut comprendre un alliage du composé III-V et d'un troisième élément notamment le InGaN ou le AlInGaN. La couche active peut comprendre des puits quantiques multiples. Elle comprend alors un empilement de couches semiconductrices formant une alternance de puits quantiques et de couches barrières.

Des modes de réalisation vont être décrits plus en détail dans le cas d'un dispositif optoélectronique dont les première et deuxième couches semiconductrices comprennent majoritairement du GaN. Toutefois, il est clair que le matériau semiconducteur composant les première et deuxième couches semiconductrices peut correspondre à n'importe quel matériau semiconducteur choisi parmi le groupe comprenant les composés III-V et les composés II-VI.

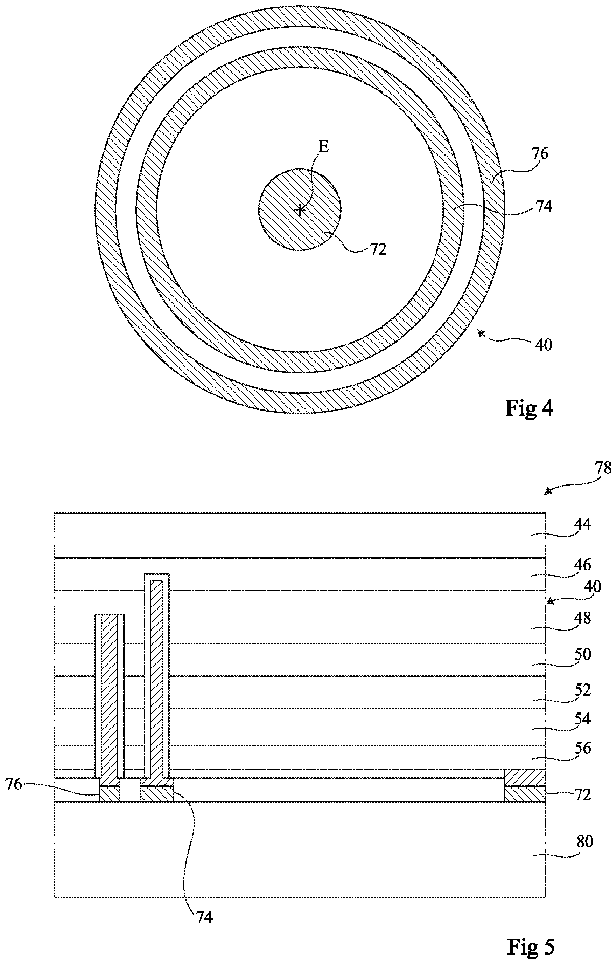

Les figures 3 et 4 représentent un mode de réalisation d'un dispositif optoélectronique 40 dont le schéma électrique équivalent est celui représenté en figure 1 et dans lequel la diode électroluminescente LED et le transistor MOS sont formés de façon intégrée.

Plus précisément, le dispositif optoélectronique 40 a sensiblement une structure à symétrie de révolution autour d'un axe E et comprend, du bas vers le haut en figure 3 :
un substrat 42 ;
une couche 44 de transition, de préférence isolante, pouvant correspondre à un empilement 44 de couches semiconductrices ;
une couche 46 de GaN dopée d'un premier type de conductivité, par exemple dopée de type N, avec une première concentration de dopants ;
une couche 48 de GaN dopée du premier type de conductivité, par exemple dopée de type N, avec une deuxième concentration de dopants supérieure strictement à la première concentration de dopants ;
une couche active 50 ;
éventuellement, une couche barrière 52, par exemple une couche de AlGaN dopée d'un deuxième type de conductivité opposé au premier type de conductivité, par exemple dopée de type P ;
une couche 54 de GaN dopée du deuxième type de conductivité opposé au premier type de conductivité, par exemple dopée de type P ;
une couche conductrice électriquement 56, par exemple métallique ;
une couche isolante électriquement 58 ;
une première tranchée 60, par exemple annulaire, traversant la totalité de l'épaisseur de la couche conductrice 56, de la couche de GaN 54 dopée de type P, de la couche barrière 52, de la couche active 50 et de la couche 48 de GaN fortement dopée de type N et traversant seulement une partie de la couche 46 de GaN moins fortement dopée de type N, la première tranchée 60 délimitant une portion centrale 61, par exemple cylindrique, dans les couches 48, 50, 52, 54 et 56 ;
une couche isolante électriquement 62 recouvrant les parois de la tranchée 60 ;
un coeur 64 en un matériau conducteur électriquement remplissant la première tranchée 60 ;
une deuxième tranchée 66, par exemple annulaire, traversant la totalité de l'épaisseur de la couche conductrice 56, de la couche 54 de GaN dopée de type P, de la couche barrière 52 et de la couche active 50 et traversant la totalité ou une partie de la couche 48 de GaN fortement dopée de type N, la deuxième tranchée 66 étant située autour de la première tranchée 60 ;
une couche isolante électriquement 68 recouvrant les parois latérales de la tranchée 66 situées en vis-à-vis de la couche conductrice 56, de la couche 54 de GaN dopée de type P, de la couche barrière 52 et de la couche active 50, recouvrant éventuellement les parois latérales de la tranchée 66 situées en vis-à-vis de la couche 48 de GaN fortement dopée de type N et ne recouvrant pas le fond de la tranchée 66 situé dans la couche 48 de GaN fortement dopée de type N ;
un coeur 70 en un matériau conducteur électriquement remplissant la deuxième tranchée 66 et en contact avec la couche 48 de GaN fortement dopée de type N ;
un premier plot conducteur électriquement 72, par exemple cylindrique, formé éventuellement d'un empilement de plusieurs couches conductrices, au contact de la couche conductrice 56 dans une ouverture 73 traversant la couche isolante 58 au niveau de la portion centrale 61 et destiné à être reliée au noeud A ;
un deuxième plot conducteur électriquement 74, par exemple annulaire, formé éventuellement d'un empilement de plusieurs couches conductrices, au contact du coeur conducteur 64 et destiné à être relié au noeud G ; et
un troisième plot conducteur électriquement 76, par exemple annulaire, formé éventuellement d'un empilement de plusieurs couches conductrices, au contact du coeur conducteur 70 et destiné à être relié au noeud C.

L'empilement des couches 48, 50, 52 et 54 de la portion centrale 61 forme la diode électroluminescente LED. Le canal 77 du transistor TMOS se forme dans la partie de la couche semiconductrice 46 qui s'étend entre le fond de la tranchée 60 et la couche 44. Le coeur conducteur 70 joue le rôle de contact de source du transistor TMOS. La polarisation de la diode électroluminescente LED est réalisée par les plots conducteurs 72 et 76.

Le substrat 42 peut correspondre à une structure monobloc ou correspondre à une couche recouvrant un support constitué d'un autre matériau. Le substrat 42 est de préférence un substrat semiconducteur, par exemple un substrat en silicium, en germanium, en carbure de silicium, en nitrure de silicium, en un composé III-V, tel que du GaN ou du GaAs, ou un substrat en ZnO ou en saphir. De préférence, le substrat 42 est un substrat de silicium monocristallin. De préférence, il s'agit d'un substrat semiconducteur compatible avec les procédés de fabrication mis en oeuvre en microélectronique. Le substrat 42 peut correspondre à une structure multicouches de type silicium sur isolant, également appelée SOI (sigle anglais pour Silicon On Insulator). A titre de variante, le substrat 42 est un substrat isolant, par exemple un substrat en saphir (Al₂O₃). Le substrat 42 peut avoir une épaisseur comprise entre 300 µm et 2000 µm.

L'empilement 44 de couches permet de favoriser la croissance par épitaxie des couches ultérieures sur le substrat 42. L'épaisseur de l'empilement 44 est comprise entre 500 nm et 15 µm, par exemple d'environ 1 µm. Dans le cas où le substrat 42 est en silicium et les couches 46, 48 et 54 sont en GaN, l'empilement 44 peut comprendre une couche barrière bloquant le gallium, par exemple une couche de nitrure d'aluminium (AlN). En effet, le gallium peut réagir fortement avec le silicium aux températures auxquelles sont amenées les couches semiconductrices au cours du procédé de fabrication du dispositif optoélectronique. L'empilement 44 peut comprendre, en outre, des couches semiconductrices qui permettent l'adaptation de maille entre les couches semiconductrices 46, 48 et le substrat 42. A titre d'exemple, dans le cas où le substrat 42 est en silicium et les couches 46, 48, et 54 sont en GaN, l'empilement 44 peut comprendre des couches de AlₓGa₁₋ₓN où x peut varier de 0 à 1 inclus.

L'épaisseur de la couche 46 de GaN faiblement dopée de type N est comprise entre 50 nm et 3 µm. La concentration de dopants de type N de la couche 46 est comprise entre 10¹⁵ atomes/cm³ et 10¹⁸ atomes/cm³, de préférence entre 5.10¹⁶ atomes/cm³ et 5.10¹⁷ atomes/cm³.

La distance minimale T entre l'empilement 44 et le fond de la première tranchée 60 est comprise entre 50 nm et 150 nm et est, de préférence, comprise entre 50 nm et 100 nm lorsque la concentration de dopants de type N de la couche 46 est supérieure à 10¹⁷ atomes/cm³.

La longueur L du canal 77 du transistor TMOS, qui correspond sensiblement à l'épaisseur du coeur conducteur 64 mesurée selon une direction perpendiculaire à la direction d'empilement des couches 46, 48, 50, 52 et 54, c'est-à-dire à la différence entre le diamètre externe et le diamètre interne du coeur conducteur 64 dans le cas d'un coeur conducteur 54 annulaire, est comprise entre 10 fois et 50 fois, de préférence entre 10 fois et 20 fois, l'épaisseur du canal, par exemple comprise entre 1 µm et 5 µm.

L'épaisseur de la couche 48 de GaN fortement dopée de type N est comprise entre 100 nm et 5 µm. La concentration de dopants de type N de la couche 48 est comprise entre 10¹⁸ atomes/cm³ et 10²⁰ atomes/cm³, par exemple environ 10¹⁹ atomes/cm³.

La couche conductrice 56 permet de réfléchir les photons émis par la diode électroluminescente.

La couche isolante 58 peut être de l'oxyde de silicium (SiO₂). La couche isolante 62 peut être en oxyde d'hafnium (HfO₂), en oxyde d'aluminium (Al₂O₃) ou en nitrure de silicium (SiNₓ). L'épaisseur de la couche isolante 62 au niveau du canal du transistor TMOS peut être comprise entre 1 nm et 40 nm.

Selon un autre mode de réalisation, la grille du transistor MOS peut être remplacée par une grille Schottky. Un transistor du type MESFET (sigle anglais pour Metal Semiconductor Field Effect Transistor) est alors obtenu. Dans ce cas, la couche isolante 62 n'est pas présente au fond de la tranchée 60 et le coeur conducteur 64 est au contact de la couche semiconductrice 46 et forme une diode Schottky à cette interface. Le coeur conducteur 64 est alors, de préférence, en un métal ayant un travail de sortie supérieur à 4 eV, par exemple le nickel.

Le fonctionnement du transistor MOS ou du transistor MESFET est le suivant. En fonction de la tension entre la grille et la source du transistor, le canal va être passant ou non passant. Lorsque le canal est passant, les électrons peuvent circuler du noeud C via le canal jusqu'à la zone active de la diode électroluminescente pour se recombiner avec des trous. Lorsque le canal n'est pas passant, les électrons ne circulent pas du noeud C vers la zone active de la diode électroluminescente.

Le fait que la diode électroluminescente LED soit directement attenante au transistor TMOS permet, de façon avantageuse, de réduire l'encombrement latéral du dispositif optoélectronique 40 par rapport au dispositif optoélectronique 10.

La figure 5 représente un mode de réalisation d'un système optoélectronique 78 dans lequel le dispositif optoélectronique 40, tel que représenté en figure 3, est fixé à un support 80, par exemple un autre circuit électronique du côté des plots conducteurs 72, 74 et 76. La surface du dispositif optoélectronique 40 sur laquelle sont formés les plots conducteurs 72, 74 et 76 étant sensiblement plane, la fixation du dispositif optoélectronique 40 au support 80 du côté des plots conducteurs 72, 74 et 76 est facilitée. Selon un mode de réalisation, comme cela est représenté en figure 5, le substrat 42 peut être retiré pour faciliter l'émission de la lumière émise dans la zone active de la diode électroluminescente LED.

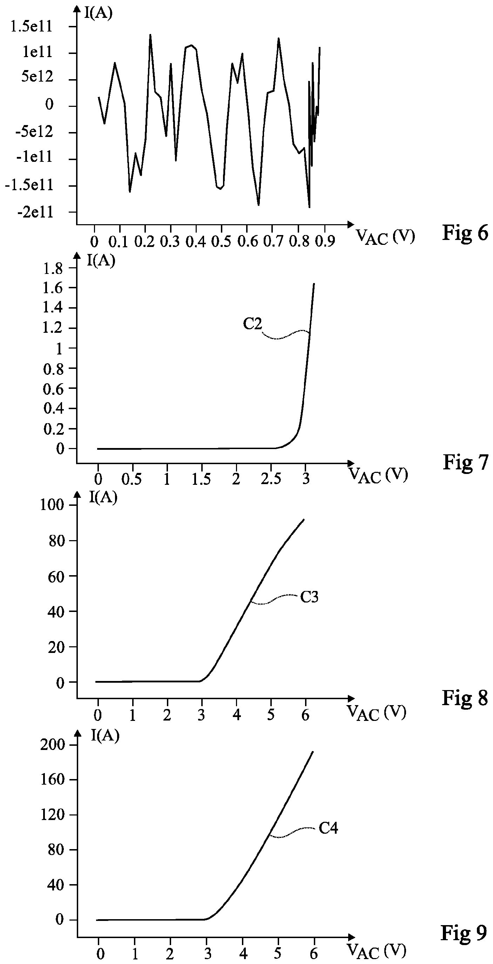

Les figures 6 à 9 représentent des courbes, respectivement C1, C2, C3 et C4, d'évolution de la densité de courant traversant la diode électroluminescente LED du dispositif optoélectronique 40 représenté en figure 3 en fonction de la tension V_{AC} entre les noeuds A et C pour différentes tensions appliquées à la grille du transistor TMOS. La tension à la grille est référencée par rapport au noeud C. Les courbes C1, C2, C3 et C4 ont été obtenues par simulation avec les paramètres suivants :
substrat 42 en silicium avec une épaisseur de 1 µm ;
couche 44 de AlN avec une épaisseur de 1 µm ;
couche 46 de GaN dopé de type N avec une épaisseur de 200 nm et une concentration de dopants de 10¹⁷ atomes/cm³ ;
couche 48 de GaN dopé de type N avec une épaisseur de 2 µm et une concentration de dopants de 10¹⁹ atomes/cm³ ;
couche active 50 comprenant des puits quantiques multiples avec une épaisseur totale de 100 nm ;
couche 52 de AlGaN dopé de type P avec une épaisseur de 100 nm et une concentration de dopants de 10¹⁹ atomes/cm³ ;
couche 54 de GaN dopé de type P avec une concentration de dopants de 10¹⁹ atomes/cm³ ;
longueur L du canal 77 du transistor TMOS de 5 µm ;
distance T de 100 nm ; et
épaisseur de la couche isolante 62 au niveau du canal 77 du transistor TMOS de 10 nm.

La courbe C1, représentée en figure 6, a été obtenue avec une tension de grille de -2 V. Sensiblement aucun courant ne traverse la diode électroluminescente LED. Le transistor TMOS joue alors le rôle d'un interrupteur ouvert.

La courbe C2, représentée en figure 7, a été obtenue avec une tension de grille de 0 V. La densité de courant traversant la diode électroluminescente LED était de 1,8 A/cm² pour une tension V_{AC} égale à 3 V.

La courbe C3 représentée en figure 8 a été obtenue avec une tension de grille de 2 V. La densité de courant traversant la diode électroluminescente LED était de 100 A/cm² pour une tension V_{AC} égale à 6 V.

La courbe C4 représentée en figure 9 a été obtenue avec une tension de grille de 8 V. La densité de courant traversant la diode électroluminescente LED était de 200 A/cm² pour une tension V_{AC} égale à 6 V. La conductivité du transistor TMOS augmente lorsque la tension de grille augmente.

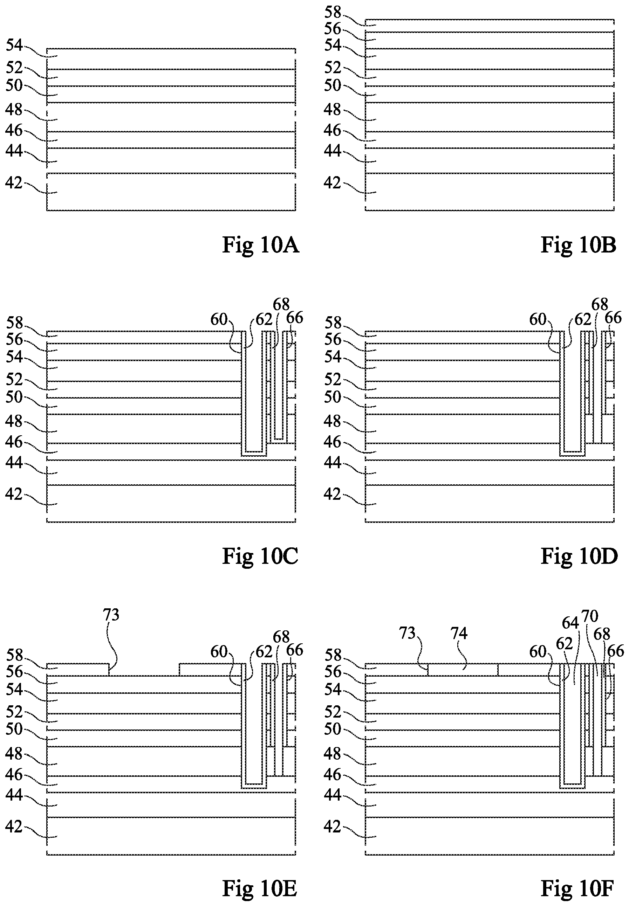

Les figures 10A à 10F sont des vues en coupe, partielles et schématiques, des structures obtenues à des étapes successives d'un mode de réalisation d'un procédé de fabrication du dispositif optoélectronique 40 représenté en figure 3.

La figure 10A représente la structure obtenue après avoir fait croître les couches semiconductrices 44, 46, 48, 50, 52 et 54 sur le substrat 42. Le procédé de croissance de ces couches peut être un procédé du type dépôt chimique en phase vapeur (CVD, sigle anglais pour Chemical Vapor Déposition) ou dépôt chimique en phase vapeur aux organométalliques (MOCVD, sigle anglais pour Metal-Organic Chemical Vapor Déposition), également connu sous le nom d'épitaxie organométallique en phase vapeur (ou MOVPE, sigle anglais pour Metal-Organic Vapor Phase Epitaxy). Toutefois, des procédés tels que l'épitaxie par jets moléculaires (MBE, sigle anglais pour Molecular-Beam Epitaxy), la MBE à source de gaz (GSMBE), la MBE organométallique (MOMBE), la MBE assistée par plasma (PAMBE), l'épitaxie par couche atomique (ALE, sigle anglais pour Atomic Layer Epitaxy) ou l'épitaxie en phase vapeur aux hydrures (HVPE, sigle anglais pour Hydride Vapor Phase Epitaxy) peuvent être utilisés.

La figure 10B représente la structure obtenue après avoir déposé la couche conductrice 56 sur la couche 54 et après avoir formé la couche isolante 58 sur la couche conductrice 56. La couche conductrice 56 peut être déposée par dépôt physique en phase vapeur (PVD, signal anglais pour Physical Vapour Déposition). La couche isolante 58 peut être déposée par CVD ou PVD.

La figure 10C représente la structure obtenue après avoir formé les première et deuxième tranchées 60, 66 et après avoir déposé la couche isolante 62 sur toutes les parois de la première tranchée 60 et la couche isolante 68 sur toutes les parois de la deuxième tranchée 66. Les première et deuxième tranchées 60, 66 peuvent être réalisées par une gravure anisotrope, par exemple une gravure réactive ionique profonde. Les couches isolantes 62, 68 peuvent être déposées par dépôt de couche atomique (ALD, sigle anglais pour Atomic Layer Déposition).

La concentration de dopants de la couche 46 qui est réduite par rapport à la couche 48 permet d'obtenir une épaisseur T de canal du transistor TMOS plus importante que celle qui serait prévue si la concentration de dopants de la couche 46 était plus importante. Ceci permet de mettre en oeuvre un procédé de gravure pour la formation de la première tranchée 60 dans lequel l'arrêt de gravure peut être obtenu avec une précision de +/- 10 nm.

La figure 10D représente la structure obtenue après avoir gravé la couche isolante 68 au fond de la tranchée 66. La gravure de la couche isolante 68 peut être réalisée par une gravure par faisceau d'ions dans la tranchée 66. Dans le présent mode de réalisation, la deuxième tranchée 66 s'étend sur toute l'épaisseur de la couche 48 de GaN fortement dopée de type N et la couche isolante 68 est retirée pour la partie de la tranchée 66 s'étendant dans la couche 48.

La figure 10E représente la structure obtenue après avoir formé l'ouverture 73 dans la couche isolante 58, par exemple par une gravure anisotrope.

La figure 10F représente la structure obtenue après avoir déposé une couche métallique sur l'ensemble de la structure représentée en figure 10E, et notamment dans l'ouverture 73, dans la première tranchée 60 et dans la deuxième tranchée 66 et après avoir retiré les portions de la couche métallique en dehors de l'ouverture 73, de la première tranchée 60 et de la deuxième tranchée 66, par exemple par une étape de gravure chimique avec arrêt de gravure sur la couche isolante 58. Dans le présent mode de réalisation, le même métal est utilisé pour former les coeurs conducteurs 64, 70 et le plot conducteur 74. A titre de variante, des matériaux différents peuvent être utilisés pour réaliser les coeurs conducteurs 64, 70 et le plot conducteur 74.

Des modes de réalisation particuliers ont été décrits. Diverses variantes et modifications apparaîtront à l'homme de l'art. En particulier, bien que des modes de réalisation de dispositifs optoélectroniques aient été décrits dans lesquels le dispositif optoélectronique comprend au moins une diode électroluminescente, il est clair que le composant électroluminescent peut être un composant différent d'une diode électroluminescente. A titre d'exemple, le composant électroluminescent peut comprendre une diode laser, par exemple un laser à émission de surface et à cavité verticale, également appelé laser VCSEL (Vertical-external-cavity surface-emitting-laser). En outre, bien que dans les modes de réalisation décrits précédemment le transistor MOS soit à canal N, il est clair que le dispositif optoélectronique peut comprendre un transistor MOS à canal P obtenu en inversant les types de conductivité des couches semiconductrices. De plus, bien que dans les modes de réalisation décrits précédemment les coeurs conducteurs 64 et 70 aient une forme annulaire à base circulaire, les coeurs conducteurs 64, 70 peuvent avoir une forme différente, par exemple une forme planaire ou une forme annulaire à base carrée.

## Revendications

1. Dispositif optoélectronique (40) comprenant un composant électroluminescent (LED) et un transistor à effet de champ (TMOS), le dispositif optoélectronique comprenant :
une première couche semiconductrice (46) d'un composé III-V ou II-VI dopée d'un premier type de conductivité ;
une couche active (50) du composant électroluminescent ;
une deuxième couche semiconductrice (54) du composé III-V ou II-VI dopée d'un deuxième type de conductivité opposé au premier type, la couche active étant prise en sandwich entre les première et deuxième couches semiconductrices,
dans lequel le canal (77) du transistor à effet de champ est situé dans la première couche semiconductrice, la première couche semiconductrice étant ininterrompue entre le transistor à effet de champ et le composant électroluminescent,
**caractérisé en ce que** le dispositif optoélectronique, comprend une première tranchée (60) traversant successivement au moins la deuxième couche semiconductrice (54), la couche active (50) et seulement une partie de la première couche semiconductrice (46), et contenant un premier coeur conducteur électriquement (64) et une première couche (62) isolante électriquement recouvrant les parois de la première tranchée au moins entre le premier coeur conducteur électriquement (64) et la deuxième couche semiconductrice (54) et entre le premier coeur conducteur électriquement (64) et la couche active (50).

2. Dispositif optoélectronique selon la revendication 1, dans lequel la première couche (62) isolante électriquement recouvre les parois de la première tranchée (60) entre le premier coeur conducteur électriquement (64) et la première couche semiconductrice (46).

3. Dispositif optoélectronique selon la revendication 1, dans lequel le premier coeur conducteur électriquement (64) est en contact avec la première couche semiconductrice (46).

4. Dispositif optoélectronique selon la revendication 3, dans lequel le travail de sortie du matériau composant le premier coeur conducteur électriquement (64) est supérieur à 4 eV.

5. Dispositif optoélectronique selon l'une quelconque des revendications 1 à 4, comprenant, en outre, une troisième couche semiconductrice (48) du composé III-V ou II-VI dopée du premier type de conductivité ayant une concentration de dopants supérieure à la concentration de dopants de la première couche semiconductrice (46), au contact de la première couche semiconductrice (46) et interposée entre la première couche semiconductrice (46) et la couche active (50).

6. Dispositif optoélectronique selon la revendication 5, comprenant une deuxième tranchée (66) traversant successivement au moins la deuxième couche semiconductrice (54), la couche active (50) et la totalité ou une partie de la troisième couche semiconductrice (48), et contenant un deuxième coeur conducteur électriquement (70) en contact avec la troisième couche semiconductrice et contenant une deuxième couche (68) isolante électriquement recouvrant les parois de la deuxième tranchée au moins entre le deuxième coeur conducteur électriquement (70) et la deuxième couche semiconductrice (54) et entre le deuxième coeur conducteur électriquement et la couche active (50).

7. Dispositif optoélectronique selon la revendication 6, comprenant un premier plot conducteur électriquement (74) en contact avec le premier coeur conducteur électriquement (64) et un deuxième plot conducteur électriquement (76) en contact avec le deuxième coeur conducteur électriquement (70), les premier et deuxième plots reposant sur une surface plane.

8. Dispositif optoélectronique selon l'une quelconque des revendications 1 à 7, dans lequel la couche active (50) est la couche d'où est émise la majorité du rayonnement électromagnétique fourni par le dispositif optoélectronique.

9. Dispositif optoélectronique selon la revendication 8, dans lequel la couche active (50) comprend un puits quantique unique ou des puits quantiques multiples.

10. Dispositif optoélectronique selon l'une quelconque des revendications 1 à 9, dans lequel la concentration de dopants de la première couche semiconductrice (46) est comprise entre 10¹⁵ atomes/cm³ et 10¹⁸ atomes/cm³, de préférence entre 5.10¹⁶ atomes/cm³ et 5.10¹⁷ atomes/cm³.

11. Dispositif optoélectronique selon l'une quelconque des revendications 1 à 10, dans lequel l'épaisseur de la deuxième couche semiconductrice (54) en vis-à-vis de la première tranchée (60) est comprise entre 50 nm et 150 nm lorsque la concentration de dopants de la deuxième couche semiconductrice (54) est supérieure à 10¹⁷ atomes/cm³.

12. Dispositif optoélectronique selon l'une quelconque des revendications 1 à 7, dans lequel l'épaisseur du premier coeur conducteur électriquement (64) est comprise entre 10 fois et 50 fois l'épaisseur de la première couche semiconductrice (46) en vis-à-vis de la première tranchée (60).

13. Procédé de fabrication d'un dispositif optoélectronique (40) comprenant un composant électroluminescent (LED) et un transistor à effet de champ (TMOS), le procédé comprenant les étapes successives suivantes :
former une première couche semiconductrice (46) d'un composé III-V ou II-VI dopée d'un premier type de conductivité ;
former une couche active (50) du composant électroluminescent ;
former une deuxième couche semiconductrice (54) du composé III-V ou II-VI dopée d'un deuxième type de conductivité opposé au premier type, la couche active étant prise en sandwich entre les première et deuxième couches semiconductrices ; et
former le canal (77) du transistor à effet de champ dans la première couche semiconductrice, la première couche semiconductrice étant ininterrompue entre le transistor à effet de champ et le composant électroluminescent, **caractérisé en ce que** le procédé comprend,
en outre, les étapes suivantes :
former une première tranchée (66) traversant successivement au moins la deuxième couche semiconductrice (54), la couche active (50) et seulement une partie de la première couche semiconductrice (46) ; et
former, dans la première tranchée, un premier coeur conducteur électriquement (64) et une première couche (62) isolante électriquement recouvrant les parois de la première tranchée au moins entre le premier coeur conducteur électriquement et la deuxième couche semiconductrice (54) et entre le premier coeur conducteur électriquement et la couche active (50).

14. Procédé selon la revendication 13, comprenant, en outre, l'étape de formation d'une troisième couche semiconductrice (48) du composé III-V ou II-VI dopée du premier type de conductivité ayant une concentration de dopants supérieure à la concentration de dopants de la première couche semiconductrice (46), au contact de la première couche semiconductrice et interposée entre la première couche semiconductrice et la couche active (50).

15. Procédé selon la revendication 14, comprenant, en outre, les étapes suivantes :
former une deuxième tranchée (66) traversant successivement au moins la deuxième couche semiconductrice (54), la couche active (50) et seulement une partie de la troisième couche semiconductrice (48) ; et
former, dans la deuxième tranchée, un deuxième coeur conducteur électriquement (70) en contact avec la troisième couche semiconductrice et une deuxième couche (68) isolante électriquement recouvrant les parois de la deuxième tranchée au moins entre le deuxième coeur conducteur électriquement et la deuxième couche semiconductrice (54) et entre le deuxième coeur conducteur électriquement et la couche active (50).

## Patentansprüche

1. Optoelektronische Vorrichtung (40) mit einer lichtemittierenden Komponente (LED) und einem Feldeffekttransistor (FET), wobei die optoelektronische Vorrichtung Folgendes aufweist:
eine erste dotierte Halbleiterschicht (46) aus einer III-V oder einer II-VI Verbindung eines ersten Leitfähigkeitstyps;
eine aktive Schicht (50) der lichtemittierenden Komponente;
eine zweite dotierte Halbleiterschicht (54) aus einer III-V oder einer II-VI Verbindung eines zweiten, dem ersten entgegengesetzten Leitfähigkeitstyps, wobei die aktive Schicht zwischen der ersten und der zweiten Halbleiterschicht angeordnet ist,
wobei der Kanal (77) des Feldeffekttransistors in der ersten Halbleiterschicht angeordnet ist, wobei die erste Halbleiterschicht zwischen dem Feldeffekttransistor und der lichtemittierenden Komponente nicht unterbrochen ist,
**dadurch gekennzeichnet, dass** die optoelektronische Vorrichtung einen ersten Graben (60) aufweist, der nacheinander wenigstens die zweite Halbleiterschicht (54), die aktive Schicht (50) und nur einen Teil der ersten Halbleiterschicht (46) kreuzt und einen ersten elektrisch leitenden Kern (64) und eine erste elektrisch isolierende Schicht (62) enthält, die die Wände des ersten Grabens wenigstens zwischen dem ersten elektrisch leitenden Kern (64) und der zweiten Halbleiterschicht (54) und zwischen dem ersten elektrisch leitenden Kern (64) und der aktiven Schicht (50) abdeckt.

2. Optoelektronische Vorrichtung nach Anspruch 1, wobei die erste elektrisch isolierende Schicht (62) die Wände des ersten Grabens (60) zwischen dem ersten elektrisch leitenden Kern (64) und der ersten Halbleiterschicht (46) abdeckt.

3. Optoelektronische Vorrichtung nach Anspruch 1, wobei der erste elektrisch leitende Kern (64) in Kontakt mit der ersten Halbleiterschicht (46) steht.

4. Optoelektronische Vorrichtung nach Anspruch 3, wobei die Arbeitsfunktion des Materials, das den ersten elektrisch leitenden Kern (64) bildet, größer als 4 eV ist.

5. Optoelektronische Vorrichtung nach einem der Ansprüche 1 bis 4, die ferner eine dritte dotierte Halbleiterschicht (48) aus der III-V oder II-VI Verbindung des ersten Leitfähigkeitstyps aufweist, und zwar mit einer Dotierungskonzentration, die größer ist als die Dotierungskonzentration der ersten Halbleiterschicht (46), die mit der ersten Halbleiterschicht (46) in Kontakt steht und die zwischen der ersten Halbleiterschicht (46) und der aktiven Schicht (50) angeordnet ist.

6. Optoelektronische Vorrichtung nach Anspruch 5, mit einem zweiten Graben (66), der nacheinander wenigstens die zweite Halbleiterschicht (54), die aktive Schicht (50) und die dritte Halbleiterschicht (48) ganz oder teilweise kreuzt und der einen zweiten elektrisch leitenden Kern (70) in Kontakt mit der dritten Halbleiterschicht und eine zweite elektrisch isolierende Schicht (68) enthält, die die Wände des zweiten Grabens wenigstens zwischen dem zweiten elektrisch leitenden Kern (70) und der zweiten Halbleiterschicht (54) und zwischen dem zweiten elektrisch leitenden Kern und der aktiven Schicht (50) abdeckt.

7. Optoelektronische Vorrichtung nach Anspruch 6, die eine erste elektrisch leitende Kontaktfläche (74) aufweist in Kontakt mit dem ersten elektrisch leitenden Kern (64) und eine zweite elektrisch leitende Kontaktfläche (76) in Kontakt mit dem zweiten elektrisch leitenden Kern (70), wobei die erste und die zweite Kontaktfläche an einer ebenen Oberfläche ruhen.

8. Optoelektronische Vorrichtung nach einem der Ansprüche 1 bis 7, wobei die aktive Schicht (50) die Schicht ist, von der der größte Teil der von der optoelektronischen Vorrichtung gelieferten elektromagnetischen Strahlung emittiert wird.

9. Optoelektronische Vorrichtung nach Anspruch 8, wobei die aktive Schicht (50) einen einzelnen Quantentopf oder mehrere Quantentöpfe aufweist.

10. Optoelektronische Vorrichtung nach einem der Ansprüche 1 bis 9, wobei die Dotierungskonzentration der ersten Halbleiterschicht (46) im Bereich von 10¹⁵ Atome/cm³ bis 10¹⁸ Atome/cm³, vorzugsweise im Bereich von 5·10¹⁶ Atome/cm³ bis 5·10¹⁷ Atome/cm³, liegt.

11. Optoelektronische Vorrichtung nach einem der Ansprüche 1 bis 10, wobei die Dicke der zweiten Halbleiterschicht (54) gegenüber dem ersten Graben (60) im Bereich von 50 nm bis 150 nm liegt, wenn die Dotierungskonzentration der zweiten Halbleiterschicht (54) größer als 10¹⁷ Atome/cm³ ist.

12. Optoelektronische Vorrichtung nach einem der Ansprüche 1 bis 7, wobei die Dicke des ersten elektrisch leitfähigen Kerns (64) im Bereich des 10- bis 50-fachen der Dicke der ersten Halbleiterschicht (46) gegenüber dem ersten Graben (60) liegt.

13. Verfahren zur Herstellung einer optoelektronischen Vorrichtung (40) mit einer lichtemittierenden Komponente (LED) und einem Feldeffekttransistor (FET), wobei das Verfahren die aufeinanderfolgenden Schritte aufweist:
Ausbilden einer ersten dotierten Halbleiterschicht (46) aus einer III-V oder einer II-VI Verbindung mit einem ersten Leitfähigkeitstyp;
Ausbilden einer aktiven Schicht (50) der lichtemittierenden Komponente;
Ausbilden einer zweiten dotierten Halbleiterschicht (54) aus der III-V oder II-VI Verbindung mit einem zweiten, dem ersten entgegengesetzten Leitfähigkeitstyp, wobei die aktive Schicht zwischen der ersten und der zweiten Halbleiterschicht angeordnet ist; und
Ausbilden des Kanals (77) des Feldeffekttransistors in der ersten Halbleiterschicht, wobei die erste Halbleiterschicht zwischen dem Feldeffekttransistor und dem lichtemittierenden Bauteil nicht unterbrochen ist, **dadurch gekennzeichnet, dass** das Verfahren ferner die folgenden Schritte aufweist:
Ausbilden eines ersten Grabens (66), der nacheinander wenigstens die zweite Halbleiterschicht (54), die aktive Schicht (50) und nur einen Teil der ersten Halbleiterschicht (46) kreuzt; und
Ausbilden in dem ersten Graben eines ersten elektrisch leitenden Kerns (64) und einer ersten elektrisch isolierenden Schicht (62), die die Wände des ersten Grabens wenigstens zwischen dem ersten elektrisch leitenden Kern und der zweiten Halbleiterschicht (54) und zwischen dem ersten elektrisch leitenden Kern und der aktiven Schicht (50) abdeckt.

14. Verfahren nach Anspruch 13, das ferner den Schritt des Ausbildens einer dritten dotierten Halbleiterschicht (48) aus der III-V oder II-VI Verbindung aufweist, und zwar mit dem ersten Leitfähigkeitstyp und mit einer Dotierungskonzentration, die größer ist als die Dotierungskonzentration der ersten Halbleiterschicht (46), in Kontakt mit der ersten Halbleiterschicht und angeordnet zwischen der ersten Halbleiterschicht und der aktiven Schicht (50).

15. Verfahren nach Anspruch 14, das ferner die folgenden Schritte aufweist:
Ausbilden eines zweiten Grabens (66), der nacheinander wenigstens die zweite Halbleiterschicht (54), die aktive Schicht (50) und nur einen Teil der dritten Halbleiterschicht (48) kreuzt; und
Ausbilden in dem zweiten Graben eines zweiten elektrisch leitenden Kerns (70) in Kontakt mit der dritten Halbleiterschicht und einer zweiten elektrisch isolierenden Schicht (68), die die Wände des zweiten Grabens wenigstens zwischen dem zweiten elektrisch leitenden Kern und der zweiten Halbleiterschicht (54) und zwischen dem zweiten elektrisch leitenden Kern und der aktiven Schicht (50) abdeckt.

## Claims

1. An optoelectronic device (40) comprising a light-emitting component (LED) and a field-effect transistor (TMOS), the optoelectronic device comprising:
a first doped semiconductor layer (46) of a III-V or II-VI compound, of a first conductivity type;
an active layer (50) of the light-emitting component;
a second doped semiconductor layer (54) of the III-V or II-VI compound, of a second conductivity type opposite to the first type, the active layer being sandwiched between the first and second semiconductor layers,
wherein the channel (77) of the field-effect transistor is located in the first semiconductor layer, the first semiconductor layer being uninterrupted between the field-effect transistor and the light-emitting component,
**characterized in that** the optoelectronic device comprises a first trench (60) successively crossing at least the second semiconductor layer (54), the active layer (50), and a portion only of the first semiconductor layer (46), and containing a first electrically-conductive core (64) and a first electrically-insulating layer (62) covering the walls of the first trench at least between the first electrically-conductive core (64) and the second semiconductor layer (54) and between the first electrically-conductive core (64) and the active layer (50).

2. The optoelectronic device of claim 1, wherein the first electrically-insulating layer (62) covers the walls of the first trench (60) between the first electrically-conductive core (64) and the first semiconductor layer (46).

3. The optoelectronic device of claim 1, wherein the first electrically-conductive core (64) is in contact with the first semiconductor layer (46).

4. The optoelectronic device of claim 3, wherein the work function of the material forming the first electrically-conductive core (64) is greater than 4 eV.

5. The optoelectronic device of any of claims 1 to 4, further comprising a third doped semiconductor layer (48) of the III-V or II-VI compound, of the first conductivity type, having a dopant concentration greater than the dopant concentration of the first semiconductor layer (46), in contact with the first semiconductor layer (46) and interposed between the first semiconductor layer (46) and the active layer (50).

6. The optoelectronic device of claim 5, comprising a second trench (66) successively crossing at least the second semiconductor layer (54), the active layer (50), and all or part of the third semiconductor layer (48), and containing a second electrically-conductive core (70) in contact with the third semiconductor layer and containing a second electrically-insulating layer (68) covering the walls of the second trench at least between the second electrically-conductive core (70) and the second semiconductor layer (54) and between the second electrically-conductive core and the active layer (50).

7. The optoelectronic device of claim 6, comprising a first electrically-conductive pad (74) in contact with the first electrically-conductive core (64) and a second electrically-conductive pad (76) in contact with the second electrically-conductive core (70), the first and second pads resting on a planar surface.

8. The optoelectronic device of any of claims 1 to 7, wherein the active layer (50) is the layer having most of the electromagnetic radiation supplied by the optoelectronic device emitted therefrom.

9. The optoelectronic device of claim 8, wherein the active layer (50) comprises a single quantum well or multiple quantum wells.

10. The optoelectronic device of any of claims 1 to 9, wherein the dopant concentration of the first semiconductor layer (46) is in the range from 10¹⁵ atoms/cm³ to 10¹⁸ atoms/cm³, preferably from 5.10¹⁶ atoms/cm³ to 5.10¹⁷ atoms/cm³.

11. The optoelectronic device of any of claims 1 to 10, wherein the thickness of the second semiconductor layer (54) opposite the first trench (60) is in the range from 50 nm to 150 nm when the dopant concentration of the second semiconductor layer (54) is greater than 10¹⁷ atoms/cm³.

12. The optoelectronic device of any of claims 1 to 7, wherein the thickness of the first electrically-conductive core (64) is in the range from 10 times to 50 times the thickness of the first semiconductor layer (46) opposite the first trench (60).

13. A method of manufacturing an optoelectronic device (40) comprising a light-emitting component (LED) and a field-effect transistor (TMOS), the method comprising the successive steps of:
forming a first doped semiconductor layer (46) of a III-V or II-VI compound, of a first conductivity type;
forming an active layer (50) of the light-emitting component;
forming a second doped semiconductor layer (54) of the III-V or II-VI compound, of a second conductivity type opposite to the first type, the active layer being sandwiched between the first and second semiconductor layers; and
forming the channel (77) of the field-effect transistor in the first semiconductor layer, the first semiconductor layer being uninterrupted between the field-effect transistor and the light-emitting component, **characterized in that** the method further comprises the steps of:
forming a first trench (66) successively crossing at least the second semiconductor layer (54), the active layer (50), and a portion only of the first semiconductor layer (46); and
forming, in the first trench, a first electrically-conductive core (64) and a first electrically-insulating layer (62) covering the walls of the first trench at least between the first electrically-conductive core and the second semiconductor layer (54) and between the first electrically-conductive core and the active layer (50).

14. The method of claim 13, further comprising the step of forming a third doped semiconductor layer (48) of the III-V or II-VI compound, of the first conductivity type, having a dopant concentration greater than the dopant concentration of the first semiconductor layer (46), in contact with the first semiconductor layer and interposed between the first semiconductor layer and the active layer (50).

15. The method of claim 14, further comprising the steps of:
forming a second trench (66) successively crossing at least the second semiconductor layer (54), the active layer (50), and a portion only of the third semiconductor layer (48); and
forming, in the second trench, a second electrically-conductive core (70) in contact with the third semiconductor layer and a second electrically-insulating layer (68) covering the walls of the second trench at least between the second electrically-conductive core and the second semiconductor layer (54) and between the second electrically-conductive core and the active layer (50).
